(19) **Europäisches Patentamt / European Patent Office / Office européen des brevets**

(11) **EP 3 234 622 B1**

(12) **FASCICULE DE BREVET EUROPEEN**

(45) Date de publication et mention
de la délivrance du brevet:
**12.12.2018 Bulletin 2018/50**

(21) Numéro de dépôt: **15820117.8**

(22) Date de dépôt: **18.12.2015**

(51) Int Cl.:
*G01R 31/36* (2006.01)     *H02J 7/00* (2006.01)

(86) Numéro de dépôt international:
**PCT/EP2015/080581**

(87) Numéro de publication internationale:
**WO 2016/097336 (23.06.2016 Gazette 2016/25)**

(54) **PROCEDE ET SYSTEME DE CHARGE ET D'EQUILIBRAGE D'UN MODULE ET/OU D'UN PACK BATTERIE COMPORTANT DES ELEMENTS ELECTROCHIMIQUES**

VERFAHREN UND SYSTEM ZUM LADEN UND AUSWUCHTEN EINES BATTERIEMODULS UND/ODER PACKS MIT ELEKTROCHEMISCHEN ELEMENTEN

METHOD AND SYSTEM FOR CHARGING AND BALANCING A BATTERY MODULE AND/OR PACK COMPRISING ELECTROCHEMICAL ELEMENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2014 FR 1462761**

(43) Date de publication de la demande:
**25.10.2017 Bulletin 2017/43**

(73) Titulaire: **Commissariat à l'Énergie Atomique et aux Énergies Alternatives 75015 Paris (FR)**

(72) Inventeurs:
• **DELAPLAGNE, Tony
38660 Sainte Marie d'Alloix (FR)**
• **HING, Sothun Eric
73000 Chambery (FR)**

(74) Mandataire: **Novaimo
ActiTech 8
60 avenue Marie Curie
Archamps Technopole
74166 Saint Julien-en-Genevois Cedex (FR)**

(56) Documents cités:
**FR-A1- 2 942 882     US-A1- 2013 038 296
US-A1- 2013 176 001     US-A1- 2013 257 382**

• **WEST S ET AL: "EQUALIZATION OF VALVE-REGULATED LEAD-ACID BATTERIES: ISSUES AND LIFE TEST RESULTS", INTELEC 2000. 22ND. INTERNATIONAL TELECOMMUNICATIONS ENERGY CONFERENCE. PHOENIX, AZ, SEPT. 10 - 14, 2000; [INTELEC. INTERNATIONAL TELECOMMUNICATIONS ENERGY CONFERENCE], NEW YORK, NY : IEEE, US, vol. CONF. 22, 10 septembre 2000 (2000-09-10), pages 439-446, XP000968731, ISBN: 978-0-7803-6408-0**

**Description**

L'invention concerne un procédé de charge et d'équilibrage d'un module et/ou d'un pack batterie comportant un ensemble d'éléments électrochimiques, par exemple de technologie Lithium-ion.

Un module et/ou un pack batterie Lithium-ion comprend un ensemble d'éléments électrochimiques, également appelés accumulateurs ou cellules, assemblés selon une configuration série et/ou parallèle selon les spécifications électriques de l'application visée. Le module et/ou le pack batterie constitue un réservoir énergétique destiné à alimenter électriquement une charge, par exemple un moteur électrique de véhicule automobile

En sortie d'usine, c'est-à-dire en fin de fabrication, les éléments électrochimiques neufs ont un comportement similaire avec une dispersion conformément à la spécification du fabricant : leurs tensions respectives varient de façon identique lors des cycles de charge et de décharge. Après un certain temps d'utilisation, et donc d'un certain nombre de cycles de charge et de décharge, les éléments de batterie subissent un vieillissement qui peut induire certaines disparités de comportement entre les éléments. Notamment, pour un état de charge, ou SOC (de l'anglais « State Of Charge »), donné du système global, il existe généralement un écart de tension non négligeable entre l'élément le plus chargé et l'élément le moins chargé de la batterie. Pour compenser cette disparité liée à un phénomène de vieillissement non homogène entre éléments , il est connu d'appliquer une procédure d'équilibrage visant à mettre tous les éléments de batterie sensiblement au même niveau de tension.

L'équilibrage peut être passif ou actif. L'équilibrage passif, également qualifié de dissipatif, vise à amener la tension de tous les éléments à celle de l'élément le moins chargé, par dissipation énergétique à travers des résistances. L'équilibrage actif consiste à transférer de l'énergie d'un élément plus chargé vers un autre élément moins chargé au sein de la batterie.

L'équilibrage est généralement déclenché en fonction de la dispersion des tensions des éléments, plus précisément en fonction de l'écart $\Delta U_{elt}$ entre la tension la plus haute et la tension la plus basse de l'ensemble des éléments de la batterie. Cet écart $\Delta U_{elt}$ correspond à une différence entre l'état de charge de l'élément de batterie le plus chargé et l'état de charge de l'élément de batterie le moins chargé. Cet écart est généralement significatif lorsque la batterie se trouve dans un état de charge faible ou dans un état de charge élevé. L'équilibrage peut toutefois être mis en oeuvre sur toute la plage de SOC de la batterie.

Les processus d'équilibrage et de charge peuvent être combinés au sein d'un même procédé comportant par exemple les étapes successives suivantes :

- une étape de charge lors de laquelle tous les éléments sont chargés par un faible courant de charge jusqu'à ce que la tension $U_{elt}MAX$ de l'élément le plus chargé atteigne une tension maximale $U_{MAX}$ préconisée par le fournisseur et/ou fabricant des éléments ;
- une étape de pause, de courte durée (par exemple de l'ordre d'une minute), lors de laquelle la charge est interrompue induisant un phénomène de relaxation, avec baisse de tension, au sein des éléments de batterie ; cette étape est importante afin de réaliser une mesure de la tension à vide (ou en circuit ouvert) de l'élément ou « OCV » (Open Circuit Voltage), qui est représentative du SOC de l'élément ;
- une étape d'équilibrage des éléments de batterie jusqu'à ce que l'écart $\Delta U_{elt}$ entre la tension la plus haute et la tension la plus basse des éléments, qui tend à diminuer durant la phase de l'équilibrage, atteigne un écart cible $\Delta U_{elt\_target}$;
- un test comparatif entre la tension la plus basse $U_{elt}MIN$ des éléments de batterie et un seuil de tension $U_{threshold}$;

les étapes de charge, de pause et d'équilibrage étant réitérées jusqu'à ce que la tension la plus basse $U_{elt}MIN$ soit supérieure ou égale à $U_{threshold}$.

L'écart cible $\Delta U_{elt\_target}$ représente l'écart entre la tension la plus élevée et la tension la plus faible de l'ensemble des éléments du module et/ou du pack batterie, qui est tolérée pour l'équilibrage. Il correspond à une différence d'état de charge entre l'élément le plus chargé et l'élément le moins chargé du module et/ou du pack batterie, jugé acceptable pour considérer que le module et/ou le pack batterie est équilibré.

La tension seuil $U_{threshold}$ correspond à un état de charge minimal souhaité pour les éléments du module et/ou du pack batterie. Elle permet de faire une discrimination entre les éléments suffisamment chargés et les éléments ayant un état de charge insuffisant.

Ces deux paramètres de tension, $\Delta U_{elt-target}$ et $U_{threshold}$, permettent d'apprécier l'équilibrage et la charge du module et/ou du pack batterie. Le système est considéré comme équilibré et chargé lorsque les deux conditions suivantes sont remplies :

- l'écart $\Delta U_{elt}$ est inférieur ou égal à $\Delta U_{elt\_target}$ ;
- la tension la plus faible $U_{elt}MIN$ est supérieure ou égale à la tension seuil $U_{threshold}$.

On constate que la durée de charge et d'équilibrage varie au cours de la vie de la batterie. Prenons l'exemple d'une batterie destinée à être chargée et équilibrée par la mise en oeuvre du procédé précédemment décrit, avec les paramètres suivants :

- $U_{max}$ valant 4,2V ;
- $U_{threshold}$ valant 4,185V, qui correspond à un état de charge ou SOC de 99% ;
- $\Delta U_{elt\_target}$ valant 15mV, qui correspond à une différence d'état de charge entre l'élément le plus chargé et l'élément le moins chargé de 1%.

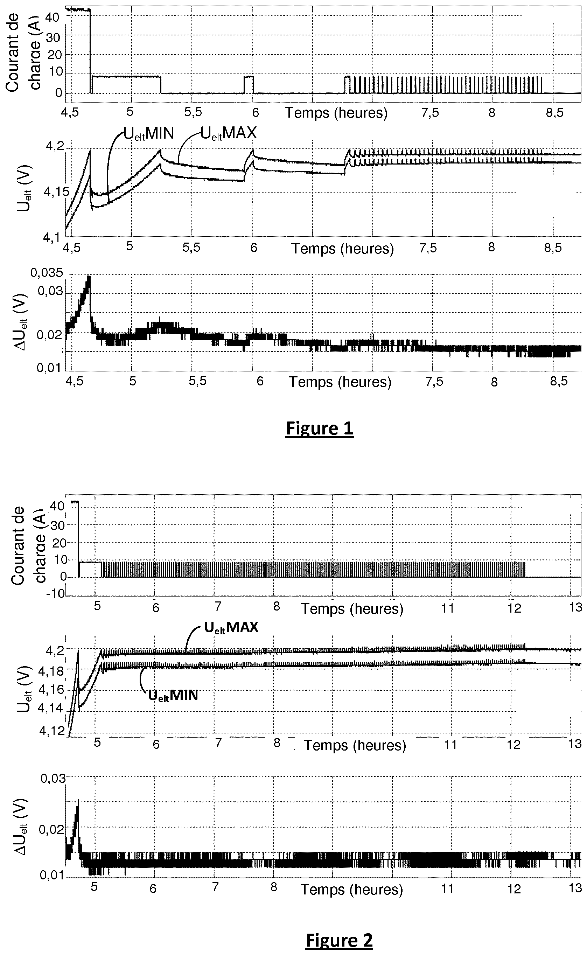

Lorsque le module et/ou le pack batterie est à l'état neuf, son SOH (de l'anglais « State Of Health », c'est-à-dire son état de santé) étant égal à 100%, sa durée de charge et d'équilibrage est de l'ordre de 8 heures, comme représenté sur la figure 1. En revanche, lorsque le module et/ou le pack batterie présente un état de vieillissement non négligeable correspondant par exemple à un SOH de 95%, le temps de charge et d'équilibrage atteint 12 heures (figure 2), voire davantage, soit une augmentation de 50% par rapport à l'état neuf. Dans certains cas de vieillissement avancé, le procédé précédemment décrit ne permet même pas d'atteindre un état chargé et équilibré. La durée de charge et d'équilibrage augmente donc de façon importante, voire inacceptable, du fait du vieillissement de la batterie.

Le document US 2013/257382 décrit un procédé de contrôle du cycle et du temps d'exécution dans des batteries pour des dispositifs électroniques portables.

Le document US 2013/176001 décrit un procédé de charge d'une batterie d'un véhicule à moteur.

Le document US 2013/038296 décrit un système de stockage de l'énergie électrique.

La présente invention vient améliorer la situation.

A cet effet, l'invention concerne un procédé de charge et d'équilibrage d'un module et/ou d'un pack batterie comportant des éléments électrochimiques, comprenant au moins une étape de charge des éléments électrochimiques suivie d'une étape d'équilibrage des éléments électrochimiques, qui sont mises en oeuvre jusqu'à ce qu'au moins une condition de charge et/ou d'équilibrage soit satisfaite, et une étape de paramétrage consistant à modifier ladite condition de charge et/ou d'équilibrage en cours de vie du module et/ou du pack batterie, caractérisé en ce que les éléments électrochimiques sont chargés jusqu'à ce que la tension la plus faible de l'ensemble des éléments électrochimiques soit supérieure ou égale à une tension seuil et, lors de l'étape de paramétrage :

- on détermine une variation de tension en circuit ouvert d'un élément électrochimique à partir de données caractéristiques de l'élément électrochimique et d'une donnée d'état de santé du module et/ou du pack batterie ;
- on calcule une valeur modifiée de la tension seuil en soustrayant ladite variation de tension en circuit ouvert déterminée à une valeur initiale de tension seuil de la batterie afin de modifier la valeur de ladite tension seuil.

L'invention consiste donc à modifier une condition de charge et/ou d'équilibrage au cours de la vie du système d'éléments électrochimiques (module et/ou pack batterie) afin de la réajuster en fonction du vieillissement du système. Grâce à cela, la durée de charge est fortement réduite. Les éléments électrochimiques étant chargés jusqu'à ce que la tension la plus faible de l'ensemble des éléments électrochimiques soit supérieure ou égale à une tension seuil (autrement dit une condition de charge et/ou d'équilibrage étant que la tension la plus faible de l'ensemble des éléments électrochimiques soit supérieure ou égale à une tension seuil), on modifie la valeur de la tension seuil lors de l'étape de paramétrage. A cet effet, le procédé de l'invention détermine une variation de la tension en circuit ouvert d'un élément électrochimique du pack ou module batterie, à partir de données caractéristiques de cet élément électrochimique et en fonction de l'état de santé (ou SOH) du module et/ou du pack batterie à un instant donné, puis utilise cette variation de tension en circuit ouvert pour modifier la tension seuil. Ainsi, on modifie, et plus précisément on réduit, la valeur de la tension seuil au cours de la vie du module et/ou du pack batterie. La tension seuil, constituant un paramètre de charge, est réajustée en cours de vie du module et/ou du pack batterie afin de tenir compte de son vieillissement.

Dans un premier mode de réalisation, la valeur de la tension seuil est modifiée à partir de données caractéristiques d'un élément électrochimique relatives à une tension en circuit ouvert de l'élément électrochimique en fonction d'une charge électrique dans l'élément.

Les données caractéristiques d'un élément électrochimique relatives à l'évolution de la tension en circuit ouvert ou tension à vide de l'élément en fonction de son état de charge ou, de manière équivalente, de la quantité d'ampères-heures stockée dans l'élément sont généralement fournies par le fabricant de l'élément. Dans le cas contraire, la tension en circuit ouvert peut être caractérisée en laboratoire.

Avantageusement, pour modifier la valeur de la tension seuil :

- on détermine une perte de capacité de charge de l'élément à partir d'une donnée d'état de santé du module et/ou du pack batterie ;
- on détermine une variation de tension en circuit ouvert d'un élément électrochimique correspondant à la perte de capacité de charge déterminée, et

- on calcule la valeur modifiée de la tension seuil en soustrayant ladite variation de tension en circuit ouvert déterminée à une valeur initiale de tension seuil de la batterie.

En cours de vie, le module et/ou le pack batterie perd en capacité électrique du fait de son vieillissement. Chaque élément du module et/ou pack batterie subit de façon analogue une perte de capacité individuelle et non homogène. Cette perte de capacité de l'élément peut être représentée par une variation de charge électrique depuis un état de charge de 100% de l'élément. A partir des données caractéristiques de l'élément, on peut déterminer une variation de la tension en circuit ouvert correspondant à cette variation de charge. La valeur modifiée de la tension seuil est ensuite calculée en diminuant la valeur initiale de la tension seuil de la variation de tension en circuit ouvert ainsi déterminée.

Dans un deuxième mode de réalisation, la valeur de la tension seuil est modifiée à partir de données caractéristiques d'un élément électrochimique relatives à une variation de tension en circuit ouvert de l'élément électrochimique en fonction de l'état de santé de l'élément, pour un état de charge électrique donné de l'élément.

Les données caractéristiques d'un élément d'un module et/ou d'un pack batterie relatives à la variation de sa tension en circuit ouvert en fonction de son état de santé, pour un état de charge donné, peuvent être obtenues à partir des données relatives à l'évolution de la tension en circuit ouvert de l'élément en fonction de son état de charge ou, de manière équivalente, de la quantité d'énergie électrique stockée dans l'élément.

Avantageusement, pour modifier la valeur de tension seuil :

- on détermine une donnée d'état de santé du module et/ou du pack batterie ;
- on détermine une variation de tension en circuit ouvert correspondant à la donnée d'état de sante déterminée ; et
- on calcule une valeur modifiée de tension seuil en soustrayant la variation de tension en circuit ouvert déterminée à une valeur initiale de tension seuil de la batterie.

Ce deuxième mode de réalisation permet de déterminer la baisse de tension à appliquer à la tension seuil directement à partir du paramètre d'état de santé de la batterie, correspondant à celui d'un élément d'un module et/ou d'un pack batterie. Ce paramètre d'état de santé est généralement déterminé par un système de gestion électronique de la batterie (BMS).

Dans un mode de réalisation particulier, lors de l'étape de charge, on charge l'ensemble des éléments électrochimiques jusqu'à ce que l'élément le plus chargé de la batterie atteigne une tension maximale prédéfinie, lesdites étapes de charge et d'équilibrage étant réitérées jusqu'à ce que la tension la plus faible des éléments de la batterie soit supérieure ou égale à la tension seuil.

Le procédé peut comprendre une étape de pause entre l'étape de charge et l'étape d'équilibrage, durant laquelle la charge est interrompue.

Dans un mode de réalisation particulier, les éléments électrochimiques sont équilibrés jusqu'à que ce que l'écart de tension entre la tension la plus élevée et la tension la plus faible des éléments soit inférieur ou égal à une valeur cible d'écart de tension (autrement dit une condition de charge et/ou d'équilibrage étant que l'écart de tension entre la tension la plus élevée et la tension la plus faible des éléments soit inférieur ou égal à une valeur cible) et, lors de l'étape de paramétrage, on modifie ladite valeur cible d'écart de tension.

Avantageusement encore, l'étape d'équilibrage est mise en oeuvre jusqu'à ce que l'écart entre la tension la plus forte et la tension la plus faible de l'ensemble des éléments électrochimiques soit inférieur ou égal à une valeur cible d'écart de tension.

L'étape de paramétrage peut être déclenchée lorsque l'un au moins des critères suivants est détecté :

- la durée de charge et d'équilibrage est supérieure ou égale à une durée seuil prédéfinie ;
- un paramètre d'état de santé de la batterie atteint une valeur critique prédéfinie ;
- un paramètre de résistance interne atteint une valeur critique prédéfinie.

L'invention concerne aussi un système de gestion d'un module et/ou pack batterie comportant une pluralité d'éléments électrochimiques, comprenant un module de commande agencé pour commander l'exécution d'une charge suivie d'un équilibrage des éléments électrochimiques, jusqu'à ce qu'au moins une condition de charge et/ou d'équilibrage soit satisfaite, et un module de paramétrage destiné à modifier ladite condition de charge et/ou d'équilibrage en cours de vie du module et/ou du pack batterie, caractérisé en ce qu'il comprend une mémoire de stockage de données caractéristiques d'un élément du module et/ou du pack batterie relatives à une tension en circuit ouvert d'un élément électrochimique et en ce que le module de paramétrage est agencé pour déterminer une variation de tension en circuit ouvert d'un élément électrochimique à partir des données caractéristiques de l'élément électrochimique et d'une donnée d'état de santé du module et/ou du pack batterie et, ladite condition de charge et/ou d'équilibrage étant que la tension la plus faible de l'ensemble des éléments électrochimiques soit supérieure ou égale à une tension seuil, pour calculer une valeur modifiée de ladite tension seuil en soustrayant ladite variation de tension en circuit ouvert déterminée à une valeur initiale de tension seuil relative à la batterie.

Le système de gestion peut avantageusement comprendre tout ou partie des caractéristiques additionnelles suivantes :

- la mémoire stocke des données caractéristiques d'un élément du module et/ou du pack batterie relatives à une tension en circuit ouvert d'un élément électrochimique en fonction d'une charge électrique, et en ce que le module de paramétrage est agencé pour déterminer une perte de capacité de charge d'un élément électrochimique puis une variation de tension en circuit ouvert de l'élément électrochimique correspondant à la perte de capacité de charge déterminée, à l'aide des dites données caractéristiques;
- la mémoire stocke des données caractéristiques d'un élément électrochimique relatives à une variation de tension en circuit ouvert de l'élément du module et/ou du pack batterie en fonction d'un paramètre d'état de santé de l'élément, pour un état de charge électrique donné, et en ce que le module de paramétrage est agencé pour déterminer une donnée d'état de santé de la batterie puis une variation de tension en circuit ouvert correspondant à la donnée d'état de sante déterminée ;
- une condition de charge et/ou d'équilibrage étant que l'écart de tension entre la tension la plus élevée et la tension la plus faible des éléments électrochimiques soit inférieur ou égal à une valeur cible d'écart de tension, le module de paramétrage est agencé pour modifier ladite valeur cible d'écart de tension ;
- le module de paramétrage comprend un bloc de déclenchement agencé pour déclencher un paramétrage, sur détection de l'un des critères suivants:

  ◦ la durée de charge et d'équilibrage est supérieure ou égale à une durée seuil prédéfinie ;
  ◦ un paramètre d'état de santé de la batterie atteint une valeur critique prédéfinie ;
  ◦ un paramètre de résistance interne atteint une valeur critique prédéfinie.

L'invention sera mieux comprise à l'aide de la description suivante d'un mode de réalisation particulier du procédé de charge et d'équilibrage de l'invention et d'une forme de réalisation particulière du système de gestion correspondant, en référence aux dessins annexés sur lesquels :

- La figure 3A représente un organigramme des étapes du procédé de charge et d'équilibrage, selon un mode de réalisation particulier de l'invention ;
- La figure 3B représente un organigramme d'une étape de paramétrage mise en oeuvre durant le procédé de charge et d'équilibrage, selon un mode de réalisation particulier ;
- La figure 4 représente une courbe montrant l'évolution de la tension en circuit ouvert d'un élément de batterie en fonction de la quantité de charge stockée dans l'élément ;
- La figure 5 représente une courbe montrant l'évolution de la variation de la tension en circuit ouvert d'un élément de batterie en fonction d'un paramètre d'état de santé (SOH de l'anglais « State of Health ») de l'élément, pour un état de charge donné de l'élément ;
- Les figures 6A, 6B et 6C représentent respectivement l'évolution du courant de charge, l'évolution de la tension de l'élément le moins chargé et de la tension de l'élément le plus chargé de la batterie et l'évolution d'un écart de tension entre l'élément le plus chargé et l'élément le moins chargé durant un processus de charge complète et d'équilibrage de la batterie ;
- La figure 7 représente un schéma bloc fonctionnel d'un système de gestion de la batterie selon une forme de réalisation particulière de l'invention.

Le procédé de l'invention permet de charger et d'équilibrer un module batterie et/ou un pack batterie. Par définition, un module et/ou pack batterie est un système comportant un ensemble d'éléments électrochimiques également appelés « accumulateurs » ou « cellules ». Ces éléments électrochimiques sont assemblés entre eux, en série et/ou parallèle, et forment un générateur électrique. Dans l'exemple de réalisation décrit ici, le module et/ou le pack batterie est de technologie Lithium-ion.

Le processus de charge consiste à charger les éléments électrochimiques afin d'atteindre un état de charge ou SOC (de l'anglais « State Of Charge ») souhaité de la batterie.

L'état de charge, ou SOC, d'un élément, d'un module et/ou d'un pack batterie, est exprimé en pourcentage. Par définition, il correspond à un rapport entre la quantité d'énergie électrique restante dans l'élément (ou quantité d'ampères-heures), et la quantité d'énergie électrique maximale qui peut être stockée dans l'élément.

Par définition, la capacité « Ct » d'un module et/ou le pack batterie est la quantité d'énergie électrique (ou quantité d'ampères-heures) qu'il est capable de restituer après avoir effectué une charge complète, pour un régime de courant de décharge donné, une tension d'arrêt et une température définies. Elle s'exprime en ampères-heures (Ah).

Le SOC d'un module et/ou d'un pack batterie est égal à 100% lorsque le système (module et/ou pack) est plein et à 0% lorsque système est totalement déchargé.

Dans l'exemple particulier de réalisation du procédé de charge et d'équilibrage qui va maintenant être décrit, la charge vise à atteindre un état de charge ou SOC du module et/ou pack batterie, et de chacun de ses éléments, d'au moins 99%, et l'équilibrage vise à ce que tous les éléments du système (module et/ou pack) atteignent un niveau de charge sensiblement égal avec un écart de charge toléré de 1 % entre les différents éléments.

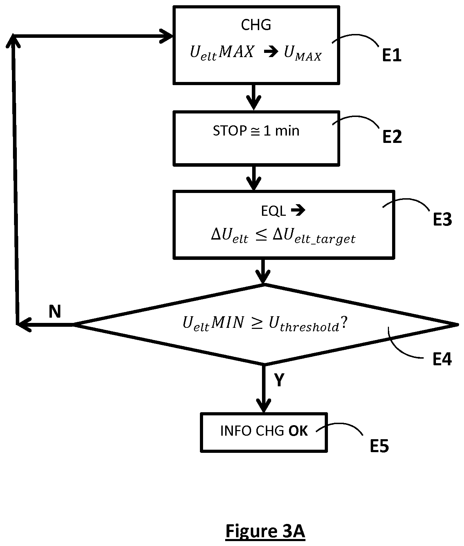

Sur la figure 3A, on a représenté des étapes du procédé de charge et d'équilibrage, selon un mode de réalisation particulier. L'exécution du procédé est contrôlée par un système de gestion de la batterie BMS (de l'anglais « Battery Management System »), qui sera décrit ultérieurement.

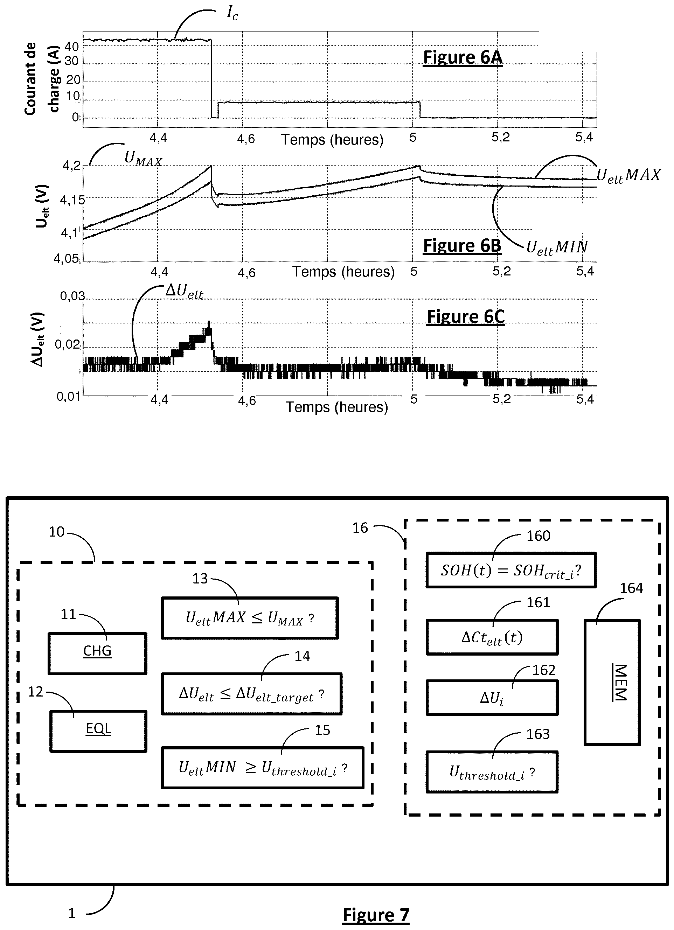

Le procédé comprend une première étape E1 de charge des éléments de d'un module et/ou pack batterie. La charge est réalisée avec un courant de charge Ic. Tous les éléments du système sont chargés en même temps. Sur la figure 6A, on a représenté l'évolution du courant de charge Ic durant la fin de phase de charge complète du système. Sur la figure 6B, on a représenté l'évolution de la tension de l'élément le plus chargé $U_{elt}MAX$ et l'évolution de la tension de l'élément le moins chargé $U_{elt}MIN$ durant la même période de charge. L'étape de charge E1 est exécutée jusqu'à ce que la tension $U_{elt}MAX$ de l'élément le plus chargé (c'est-à-dire la tension la plus haute des tensions respectives des éléments du module et/ou du pack batterie) atteigne une tension maximale de sécurité $U_{MAX}$, par exemple égale à 4,2V. La tension $U_{MAX}$ correspond à un état de charge de 100%. Cette première étape de charge E1 est donc limitée dans le sens où elle est exécutée jusqu'à ce que la tension $U_{elt}MAX$ de l'élément le plus chargé de la batterie atteigne $U_{MAX}$.

L'étape de charge E1 est suivie d'une étape de pause E2, durant laquelle la charge est interrompue, le courant de charge Ic étant nul. La durée de l'étape E2 est par exemple de l'ordre d'une minute. Durant la pause E2, la tension en circuit ouvert des éléments diminue du fait d'un phénomène de relaxation, comme cela apparaît sur la figure 6B.

Après l'étape E2, le procédé se poursuit par une étape d'équilibrage E3. Dans le mode de réalisation décrit ici, l'équilibrage est passif. Il consiste à dissiper une partie de l'énergie des éléments les plus chargés à travers des résistances. L'équilibrage vise à ce que les différents éléments du module et/ou du pack batterie atteignent sensiblement un même niveau de charge, correspondant à une même tension. A l'issue de l'étape d'équilibrage, l'écart de tension $\Delta U_{elt}$ entre la tension la plus élevée et la tension la plus faible des éléments doit être inférieur ou égal à une valeur cible $\Delta U_{elt\_target}$. Cette valeur cible $\Delta U_{elt\_target}$ d'écart de tension correspond à une différence tolérée d'état de charge entre l'élément le plus chargé et l'élément le moins chargé de la batterie. Par exemple $\Delta U_{elt-target}$ vaut 15mV, ce qui correspond ici à une différence tolérée d'état de charge de 1% sur la plage haute de SOC. L'étape d'équilibrage E3 est donc exécutée, autrement dit les éléments électrochimiques sont équilibrés, jusqu'à ce que l'écart de tension $\Delta U_{elt}$ qui diminue du fait de l'équilibrage devienne inférieur ou égale à $\Delta U_{elt\_target}$. En variante, l'équilibrage pourrait être de type actif.

A l'issue de l'étape d'équilibrage E3, une étape de test E4 est exécutée. Le test consiste à comparer la tension la plus faible $U_{elt}MIN$ des tensions respectives des différents éléments du module et/ou du pack batterie à une tension seuil $U_{threshold\_i}$ afin de déterminer si la tension la plus faible $U_{elt}MIN$ est supérieure ou égale au seuil $U_{threshold\_i}$. Selon l'invention, la valeur du seuil $U_{threshold\_i}$ est modifiée en cours de vie de la batterie. Initialement, en sortie d'usine (c'est-à-dire à l'état neuf), la tension seuil est notée $U_{threshold\_0}$. Le seuil de tension $U_{threshold\_i}$ correspond à un état de charge électrique minimal souhaité pour chaque élément de batterie. Par exemple, $U_{threshold\,0}$ vaut 4,185V, ce qui correspond à un état de charge de 99% pour un élément du module et/ou du pack batterie.

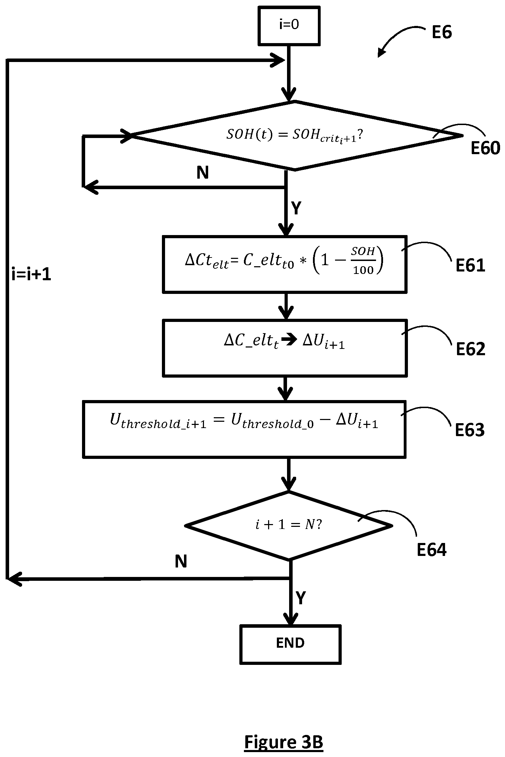

Si le test E4 est négatif (branche N sur la figure 3A), autrement dit si la tension $U_{elt}MIN$ est inférieure au seuil $U_{threshold\_i}$, les étapes successives de charge E1, de pause E2 et d'équilibrage E3 sont réitérées. Si le test E4 est positif (branche Y sur la figure 3), autrement dit si la tension $U_{elt}MIN$ est supérieure ou égale au seuil $U_{threshold\_i}$, le module et/ou le pack batterie est considérée comme chargée et équilibrée et le procédé passe à une étape E5 de signalisation de fin de charge. Les étapes de charge E1, de pause E2 et d'équilibrage E3 sont réitérées autant de fois que nécessaire jusqu'à ce que le test E4 devienne positif.

Le module et/ou le pack batterie est ainsi chargé et équilibré lorsque les deux conditions suivantes sont satisfaites :

- $U_{elt}MIN \geq U_{threshold\_i}$ et
- $\Delta U_{elt} \leq \Delta U_{elt\_target}$.

Les étapes qui viennent d'être décrites permettent de réaliser une charge complète, ou quasi-complète, et un équilibrage du système. Elles sont réalisées à chaque fois qu'un utilisateur souhaite recharger le module et/ou le pack batterie, après une décharge complète ou partielle de celle-ci. Bien entendu, le processus combiné de charge et d'équilibrage pourrait être mis en oeuvre pour atteindre tout état de charge, ou SOC, souhaité, par exemple 50% du SOC.

Selon l'invention, le procédé comprend en outre une étape E6 de paramétrage du seuil de tension $U_{threshold\_i}$. L'étape E6 décrite ci-après est exécutée tout au long de la vie du module et/ou du pack batterie. Elle comprend plusieurs sous-étapes représentées sur la figure 3B.

Notons d'emblée que l'indice « i » représente un indice de tension seuil $U_{threshold\_i}$. Cet indice « i » est un entier naturel supérieur ou égal à 0 selon le numéro d'ordre de la tension seuil. Il vaut zéro en sortie d'usine du module et/ou du pack batterie, la tension $U_{threshold\_0}$ représentant la tension seuil telle que fixée en sortie d'usine. L'indice i est incrémenté de 1 après chaque nouveau paramétrage de $U_{threshold\_i}$.

L'étape de paramétrage E6 comprend une première sous-étape de test E60 consistant à détecter si un critère déclencheur d'un paramétrage du seuil de tension est rempli. Dans l'exemple de réalisation décrit ici, le critère utilisé est relatif à un paramètre d'état de sante ou SOH (de l'anglais « State of Health »).

Le paramètre SOH est un indicateur de l'état général de santé du module et/ou du pack batterie. Sa valeur est déterminée par le système de gestion BMS. Il est généralement exprimé en pourcentage et se calcule, à un instant t au cours de la vie de la batterie, par la relation suivante :

$$SOH(t) = \frac{Ct_{bat}(t)}{Ct_{bat}(t_0)} \cdot 100 \qquad (1)$$

où :

- $SOH(t)$, exprimé en pourcentage, représente l'état de santé de la batterie à l'instant t ;
- $Ct_{bat}(t)$, exprimé en Ah, représente la capacité de charge électrique du module et/ou du pack batterie, mesurée lors d'une phase de charge complète suivie d'une décharge complète à régime connu, l'instant $t$ représentant l'instant où cette séquence décrite précédemment est effective ;
- $Ct_{bat}(t_0)$, exprimé en Ah, représente la capacité de charge électrique de la batterie, mesurée lors d'une phase de charge complète suivie d'une décharge complète à régime connu, l'instant $t_0$ représentant l'instant où cette séquence décrite précédemment a été réalisée pour la 1$^{\text{ère}}$ fois, soit en sortie d'usine.

Le paramètre SOH tend à diminuer au cours de la vie du module et/ou du pack batterie. Plusieurs valeurs critiques de SOH peuvent être prédéfinies. Ces valeurs sont successives, dans le sens décroissant. Elles sont notées $SOH_{crit\_i+1}$ avec i $=$ 0, 1, 2, ..., N-1, $SOH_{crit\_1}$ étant la plus grande valeur critique et $SOH_{crit\_N}$ la plus petite valeur critique. L'étape E60 permet de détecter ces valeurs critiques $SOH_{crit\_i+1}$ tout au long de la vie du système. Elle est mise en oeuvre par le système BMS. Elle permet de surveiller ici le critère relatif au SOH, de manière à déclencher un paramétrage et une modification de la valeur du seuil de tension lorsque l'on détecte que le critère surveillé est rempli, c'est-à-dire qu'une valeur critique $SOH_{crit\_i+1}$ est atteinte.

Dans une première variante, le critère déclencheur d'un paramétrage du seuil de tension $U_{threshold\_i}$, peut être relatif à la durée de charge complète et d'équilibrage de la batterie. Si cette durée est supérieure ou égale à un seuil prédéfini, par exemple 6 heures, alors un paramétrage est déclenché. Dans une deuxième variante, le critère déclencheur d'un paramétrage du seuil de tension $U_{threshold\_i}$, peut être un paramètre relatif à la résistance interne du système atteignant une valeur critique prédéfinie.

Le test E60 est réitéré tant qu'il est négatif, c'est-à-dire tant que le critère surveillé n'est pas rempli.

En cas de test E60 positif, le procédé se poursuit par une sous-étape E61 de détermination d'une perte de capacité $\Delta Ct_{elt}(t)$ d'un élément de batterie, à partir de la valeur du SOH à l'instant t, $SOH(t)$, fournie par le système de gestion BMS et à l'aide de la relation (4) explicitée ci-après.

A un instant t, la capacité de charge du module et/ou du pack batterie peut être déduite de la relation suivante, obtenue à partir de la relation (1) :

$$Ct_{bat}(t) = \frac{SOH(t)}{100} \cdot Ct_{bat}(t_0) \qquad (2)$$

De manière analogue, à un instant t, la capacité de charge électrique d'un élément du module et/ou du pack batterie est donnée par la relation suivante :

$$Ct_{elt}(t) = \frac{SOH(t)}{100} \cdot Ct_{elt}(t_0) \qquad (3)$$

où $Ct_{elt}(t_0)$ et $Ct_{elt}(t)$ représentent les capacités de charge d'un élément respectivement à l'instant $t_0$ de sortie d'usine et à l'instant t.

Entre l'instant $t_0$ et l'instant t, chaque élément de la batterie subit une perte de capacité de charge électrique $\Delta Ct_{elt}(t)$ en raison de son vieillissement. Cette perte de capacité $\Delta Ct_{elt}(t)$ est fonction de l'état de santé SOH du module et/ou du pack batterie à l'instant t et peut être exprimée par la relation suivante :

$$\Delta \mathrm{Ct}_{\mathrm{elt}}(\mathrm{t}) = \mathrm{Ct}_{\mathrm{elt}}(\mathrm{t_0}) - \mathrm{Ct}_{\mathrm{elt}}(\mathrm{t}) = \mathrm{Ct}_{\mathrm{elt}}(\mathrm{t_0}) * \left(1 - \frac{\mathrm{SOH(t)}}{100}\right) \qquad (4)$$

Puis, lors d'une sous-étape E62, la perte de capacité $\Delta Ct_{elt}(t)$ est convertie en une variation de tension correspondante, notée $\Delta U_{i+1}$.

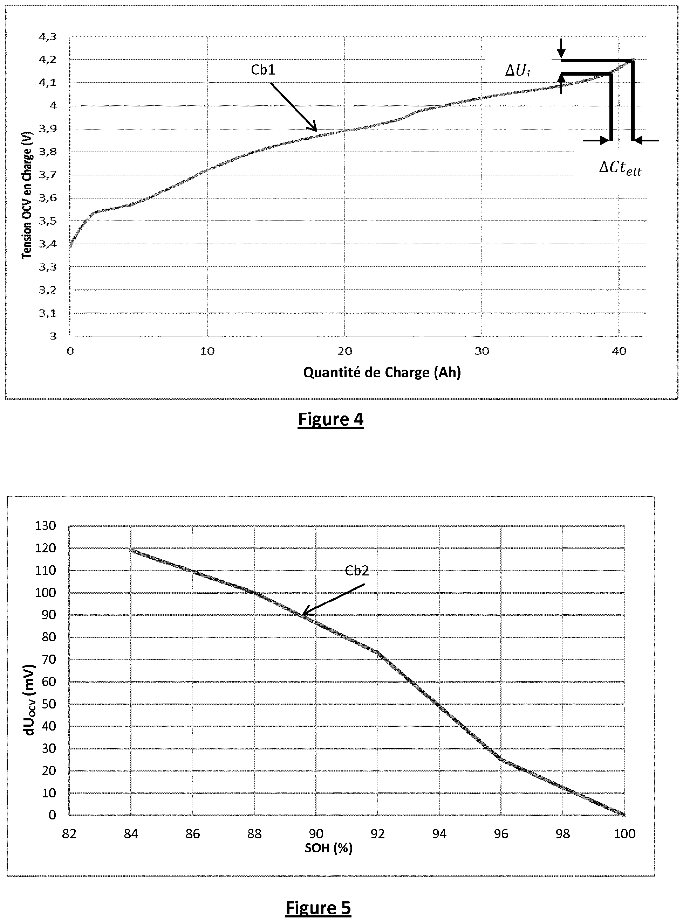

Selon un premier mode de réalisation, la conversion de perte de capacité $\Delta Ct_{elt}(t)$ en une variation de tension $\Delta U_{i+1}$ est réalisée à partir de données DATAS1 relatives à la tension en circuit ouvert d'un élément du module et/ou du pack batterie en fonction de la quantité d'énergie électrique chargée dans l'élément, c'est-à-dire de la charge électrique de l'élément, (ou, de manière équivalente, en fonction de son SOC variant entre 0% et 100%). Sur la figure 4, ces données DATAS1 sont représentées sous la forme d'une courbe Cb1 qui montre l'évolution de la tension en circuit ouvert d'un élément, exprimée en Volts, en fonction de la quantité d'énergie électrique chargée, exprimée en Ampère-heure. Les données DATAS1 et/ou la courbe Cb1 sont des données caractéristiques et spécifiques de la technologie de batterie. Elles peuvent être fournies par le fabricant ou caractérisées en laboratoire. A partir de cette courbe Cb1, ou de ces données DATAS1, relatives à l'évolution de la tension en circuit ouvert d'un élément du module et/ou du pack batterie en fonction de sa charge électrique (ou de son SOC), le système BMS détermine à quelle variation de la tension en circuit ouvert $\Delta U_{i+1}$ correspond une variation de charge électrique égale à la perte de capacité $\Delta Ct_{elt}(t)$, pour l'état de charge considéré, ici pour un SOC proche de 100%. En l'espèce, on détermine à quelle variation de tension en circuit ouvert correspond une variation de charge équivalente à la perte de capacité entre la capacité maximale de l'élément en sortie d'usine, notée $Ct_{elt}(t_0)$, qui correspond à un SOC proche de 100%, et la capacité réduite de l'élément vieilli égale à $Ct_{elt}(t_0)$ - $\Delta Ct_{elt}(t)$. Sur la figure 4, on a représenté la variation de tension en circuit ouvert correspondant à la perte de capacité $\Delta Ct_{elt}(t)$. La variation de la tension en circuit ouvert ainsi déterminée correspond à la baisse de tension $\Delta U_{i+1}$ à appliquer à la valeur initiale $U_{threshold\_0}$ de la tension seuil.

La sous-étape E62 est suivie d'une sous-étape E63 de calcul d'une valeur modifiée du seuil de tension $U_{threshold\_i+1}$, avec i = 0, 1, 2, ..., i étant l'indice de la tension seuil. Notons $U_{threshold\_0}$ la valeur initiale du seuil de tension et $U_{threshold\_i+1}$ une valeur modifiée du seuil de tension. Le calcul du seuil de tension modifié est réalisé à l'aide de la relation suivante :

$$U_{threshold\_i+1} = U_{threshold\_0} - \Delta U_{i+1} \qquad (5)$$

Suite à l'étape E63, il est prévu une étape de test E64 afin de vérifier si l'indice i+1 est égal à N. Si le test est positif, l'étape de paramétrage E6 est terminée (étape E65). Si le test est négatif, l'indice i est incrémenté de 1 et le procédé revient ensuite à l'étape E60 afin de surveiller l'atteinte de la valeur critique suivante de tension seuil.

Prenons l'exemple d'un module et/ou d'un pack batterie Lithium-ion comportant des éléments caractérisés par la courbe Cb1 de la figure 4. En sortie d'usine, la tension maximale de ces éléments $U_{MAX}$, correspondant à un état de charge ou SOC de 100%, est égale à 4,2V, ce qui correspond à une capacité de charge électrique égale à 42Ah. Pour réaliser la charge et l'équilibrage de la batterie, on utilise une valeur initiale de tension seuil $U_{threshold\_0}$ égale à 4,185V, ce qui correspond à un état de charge de 99%, et un écart de tension cible $\Delta U_{ect\_target}$ égal à 15mV, ce qui correspond à une différence d'état de charge de 1% entre la cellule la plus chargée et la cellule la moins chargée. Après sortie d'usine de la batterie, celle-ci subit de multiples cycles de charge et décharge, chaque cycle de charge étant mis en oeuvre par l'exécution des étapes E1 à E4 précédemment décrites. En cours de vie, le SOH du module et/ou du pack batterie diminue et atteint à un instant t un premier SOH critique, $SOH_{crit\_1}$ par exemple égal à 96%. Cela déclenche l'exécution d'un paramétrage E6 du seuil de tension, lors de la sous-étape de déclenchement E60. A partir de la valeur du SOH, lors d'une sous-étape E61, le système BMS calcule la perte de capacité de charge électrique de chaque élément de batterie par la relation (4), la capacité de charge initiale de l'élément de batterie (en sortie d'usine) étant égale à 42Ah : $\Delta Ct_{elt}(t)$ = 42 * (1 - 0,96) = 1,68Ah. Lors d'une sous-étape E62, le système BMS calcule une variation de tension $\Delta U_1$ correspondant à $\Delta Ct_{elt}(t)$ = 1,68Ah à partir des données DATAS1 ou de la courbe correspondante Cb1. En l'espèce, $\Delta U_1$ vaut 25mV. Enfin, lors d'une sous-étape E63, on calcule le seuil de tension modifié $U_{threshold\_1}$ par la relation suivante :

$$U_{threshold_1} = U_{threshold\_0} - \Delta U_1 = 4,185 - 0,025 = 4,16V$$

L'étape de paramétrage E6, telle que précédemment décrite, peut être mise en oeuvre pour une succession de valeurs « critiques » de SOH, par exemple égales à 96%, 92%, 88% et 84%. Le tableau ci-dessous issu de la figure 5 contient, pour chacune de ces valeurs critiques d'état de santé, avec i allant de 0 à 4, la capacité de charge d'un élément de batterie, la perte de capacité de l'élément (par rapport à son état neuf, en sortie d'usine), la variation de tension seuil correspondante et la valeur modifiée de la tension seuil:

| i | 0 | 1 | 2 | 3 | 4 |
|---|---|---|---|---|---|
| $SOH_{crit\_i}$ i | 100 | 96 | 92 | 88 | 84 |
| $Ct_{elt}$ (Ah) | 42 | 40.32 | 38.64 | 36.96 | 35.28 |
| $\Delta Ct_{elt}$ (Ah) | 0 | 1.68 | 3.36 | 5.04 | 6.72 |
| $\Delta U_i$ (mV) | 0 | 25 | 73 | 100 | 119 |
| $U_{threshold\_i}$ | 4,185 | 4,16 | 4,112 | 4,085 | 4,066 |

Dans un autre exemple de réalisation, le seuil de tension $U_{threshold\_0}$ est modifié en un seuil de tension $U_{threshold\_1}$ lorsque le SOH est égal à 95%. Dans ce cas, la variation de tension $\Delta U_1$ déterminée par la mise en oeuvre des sous-étapes E61 et E62 est égale à 40mV. Il en résulte un seuil de tension modifié $U_{threshold\_1}$ égal à 4,145V, déterminé lors de la sous-étape E63. Les figures 6A-6C représentent un cycle de charge et d'équilibrage mis en oeuvre avec la tension de seuil $U_{threshold\_1}$ égal à 4,145V, le SOH étant égal ou proche de 95%. Plus précisément, on a représenté l'évolution du courant de charge Ic (figure 6A), des tensions respectives de l'élément le plus chargé et de l'élément le moins chargé (figure 6B), et de l'écart de tension $\Delta U_{elt}$ entre l'élément le plus chargé et l'élément le moins chargé (figure 6C). On constate qu'en utilisant la valeur modifiée $U_{threshold\_1}$ de seuil de tension, la durée de la charge et de l'équilibrage est de l'ordre de 5h, alors qu'elle nécessiterait environ 12h en utilisant la tension seuil initiale $U_{threshold\_0}$, comme cela ressort de la figure 2.

Dans un deuxième mode de réalisation, la détermination de la variation de tension $\Delta U_{i+1}$ est réalisée directement à partir de la valeur du SOH. Dans ce cas, le système BMS dispose de données DATAS2 relatives à la variation de la tension en circuit ouvert d'un élément de batterie ($dU_{OCV}$) en fonction de l'état de santé, ici du SOH, de l'élément, pour un état de charge électrique donné de l'élément. Ces données DATAS2 peuvent être représentées par une courbe Cb2, telle que représentée sur la figure 5, montrant l'évolution de la variable $dU_{OCV}$ en fonction du SOH de l'élément de batterie pour un état de charge donné de l'élément ici de 100%. Les données DATAS2 et/ou la courbe correspondante Cb2 sont obtenues à partir des données DATAS1. Selon cette variante, la diminution de tension $\Delta U_{i+1}$ à appliquer à la tension seuil $U_{threshold\_0}$ initiale est déterminée directement à partir de la valeur du SOH à l'aide des données DATAS2 ou de la courbe Cb2. Elle est égale à la valeur de $dU_{OCV}$ correspondant au SOH considéré sur la courbe Cb2.

La figure 7 représente un schéma bloc fonctionnel du système BMS 1 de gestion du module et/ou du pack batterie, selon une forme de réalisation particulière de l'invention. Le rôle du système BMS 1 est, de façon connue, destiné à surveiller l'état des différents éléments de la batterie, notamment les paramètres suivants :

- tension de chaque élément de batterie ($U_{elt}$) et tension totale ($U_{bat}$) du module et/ou du pack batterie;
- état de charge (SOC) du module et/ou du pack batterie;
- état de santé (SOH) du module et/ou du pack batterie.

Le système BMS 1 a également pour fonction de contrôler la charge et l'équilibrage du module et/ou du pack batterie.

Par souci de clarté, seuls les éléments du BMS nécessaires à la compréhension de l'invention seront décrits ci-après.

A cet effet, il comprend un module de commande 10 destiné à commander l'exécution des étapes E1 à E4 de charge et d'équilibrage. Il comprend :

- un bloc 11 de contrôle de la charge, destiné à commander l'alimentation en courant de charge Ic des éléments, avec des phases de charge et de pause ;
- un bloc 12 de contrôle de l'équilibrage, destiné à commander une dissipation d'énergie à travers des résistances des éléments les plus chargés de sorte que tous les éléments de batterie atteignent sensiblement un même niveau de tension (image du SOC) ;
- un premier bloc de test 13 destiné à surveiller la tension $U_{elt}MAX$ de l'élément de batterie le plus chargé et à détecter lorsqu'elle atteint la tension maximale $U_{max}$ ;
- un deuxième bloc de test 14 destiné à surveiller l'écart de tension $\Delta U_{elt}$ à un instant t entre l'élément le plus chargé et l'élément le moins chargé et détecter s'il est inférieur ou égal à l'écart cible $\Delta U_{elt\_target}$ ;

- un troisième bloc de test 15 destiné à surveiller la tension $U_{elt}MIN$ de l'élément le moins chargé et à détecter lorsqu'elle est supérieure ou égale à une tension seuil $U_{threshold\_i}$.

En outre, le système BMS 1 comprend un module 16 de paramétrage de la tension seuil $U_{threshold}$. Le module 16 comprend :

- un bloc de déclenchement 160 ;
- un bloc 161 de détermination d'une perte de capacité de charge du module et/ou du pack batterie ;
- un bloc 162 de détermination d'une variation de la tension en circuit ouvert d'un élément de batterie correspondant à une perte de capacité déterminée ;
- un bloc 163 de calcul d'une tension seuil modifiée ;
- une mémoire 164 de stockage des données DATAS1 et/ou de la courbe Cb1, ou des données DATAS2 et/ou de la courbe Cb2.

Les blocs 160, 161, 162 et 163 sont destinés à mettre en oeuvre les étapes E60, E61, E62, E63 respectivement.

Le module de commande 10 et le module de paramétrage 16 sont des modules logiciels comportant des instructions logicielles destinées à mettre en oeuvre les étapes correspondantes du procédé précédemment décrit, lorsque les modules logiciels sont exécutés par un microprocesseur, ici un microprocesseur du système BMS.

De façon plus générale, le procédé de charge et d'équilibrage comprend au moins une étape E1 de charge des éléments électrochimiques suivie d'une étape E3 d'équilibrage des éléments électrochimiques, mises en oeuvre jusqu'à ce qu'au moins une condition de charge et/ou d'équilibrage soit satisfaite, et l'étape de paramétrage E6 consiste à modifier ladite condition de charge et/ou d'équilibrage en cours de vie du module et/ou du pack batterie. Cette condition est donc « paramétrable ». Le système de gestion du module et/ou du pack batterie comprend, de façon plus générale, un module de commande agencé pour commander l'exécution d'une charge suivie d'un équilibrage des éléments électrochimiques, jusqu'à ce qu'au moins une condition de charge et/ou d'équilibrage soit satisfaite, et un module de paramétrage destiné à modifier ladite condition de charge et/ou d'équilibrage en cours de vie du module et/ou du pack batterie.

Dans la description qui précède, la condition paramétrable de charge et/ou d'équilibrage est que la tension la plus faible de l'ensemble des éléments électrochimiques soit supérieure ou égale à une tension seuil ($U_{threshold\_i}$). Les éléments électrochimiques sont chargés jusqu'à ce que cette condition soit satisfaite. L'étape de paramétrage consiste à modifier la valeur de la tension seuil $U_{threshold-i}$ en cours de vie du module et/ou du pack batterie.

En variante, la condition paramétrable de charge et/ou d'équilibrage est que l'écart de tension $\Delta U_{elt}$ entre la tension la plus élevée et la tension la plus faible des éléments soit être inférieur ou égal à une valeur cible d'écart de tension $\Delta U_{elt_{target}}$. Les éléments électrochimiques sont équilibrés jusqu'à ce que cette condition soit satisfaite. Dans ce cas, l'étape de paramétrage, mise en oeuvre par le module de paramétrage, consiste à modifier ladite valeur cible d'écart de tension $\Delta U_{elt_{target}}$ au cours de la vie du module et/ou pack batterie.

## Revendications

1. Procédé de charge et d'équilibrage d'un module et/ou d'un pack batterie comportant des éléments électrochimiques, comprenant au moins une étape (E1) de charge des éléments électrochimiques suivie d'une étape (E3) d'équilibrage des éléments électrochimiques, qui sont mises en oeuvre jusqu'à ce qu'au moins une condition de charge et/ou d'équilibrage soit satisfaite, et une étape de paramétrage (E6) consistant à modifier ladite condition de charge et/ou d'équilibrage en cours de vie du module et/ou du pack batterie, les éléments électrochimiques étant chargés jusqu'à ce que la tension la plus faible de l'ensemble des éléments électrochimiques soit supérieure ou égale à une tension seuil ($U_{threshold\_i}$) et **caractérisé en ce que**, lors de l'étape de paramétrage :

    • on détermine une variation de tension en circuit ouvert ($\Delta U_{i+1}$) d'un élément électrochimique à partir de données caractéristiques de l'élément électrochimique et d'une donnée d'état de santé du module et/ou du pack batterie ;
    • on calcule (E63) une valeur modifiée de la tension seuil en soustrayant ladite variation de tension en circuit ouvert déterminée ($\Delta U_{i+1}$) à une valeur initiale ($U_{threshold\_0}$) de tension seuil de la batterie afin de modifier la valeur de la tension seuil.

2. Procédé selon la revendication 1, **caractérisé en ce que** la valeur de la tension seuil ($U_{threshold\_i}$) est modifiée à partir de données caractéristiques d'un élément électrochimique relatives à une tension en circuit ouvert de l'élément électrochimique en fonction d'une charge électrique dans l'élément.

**3.** Procédé selon la revendication précédente, **caractérisé en ce que**, pour modifier la valeur de tension seuil :

• on détermine (E61) une perte de capacité de charge ($\Delta Ct_{elt}$) de l'élément à partir d'une donnée d'état de santé du module et/ou du pack batterie ;
• on détermine (E62) une variation de tension en circuit ouvert ($\Delta U_{i+1}$) d'un élément électrochimique correspondant à la perte de capacité de charge déterminée, et
• on calcule (E63) la valeur modifiée de la tension seuil en soustrayant ladite variation de tension en circuit ouvert déterminée ($\Delta U_{i+1}$) à une valeur initiale ($U_{threshold\_0}$) de tension seuil de la batterie.

**4.** Procédé selon la revendication 1, **caractérisé en ce que** la valeur de la tension seuil est modifiée à partir de données caractéristiques d'un élément électrochimique relatives à une variation de tension en circuit ouvert de l'élément électrochimique en fonction de l'état de santé (SOH) de l'élément, pour un état de charge électrique (SOC) donné de l'élément.

**5.** Procédé selon la revendication précédente, **caractérisé en ce que**, pour modifier la valeur de tension seuil :

• on détermine une donnée (SOH) d'état de santé du module et/ou du pack batterie ;
• on détermine une variation de tension en circuit ouvert ($\Delta U_{i+1}$) correspondant à la donnée d'état de santé déterminée ; et
• on calcule une valeur modifiée de tension seuil en soustrayant la variation de tension en circuit ouvert déterminée à une valeur initiale de tension seuil de la batterie $(U_{threshold\_0})$.

**6.** Procédé selon l'une des revendications précédentes, **caractérisé en ce que**, lors de l'étape de charge (E1), on charge l'ensemble des éléments électrochimiques jusqu'à ce que l'élément le plus chargé de la batterie $(U_{elt}MAX)$ atteigne une tension maximale prédéfinie ($U_{MAX}$), lesdites étapes de charge et d'équilibrage (E1, E3) étant réitérées jusqu'à ce que la tension la plus faible $(U_{elt}MIN)$ des éléments de la batterie soit supérieure ou égale à la tension seuil ($U_{threshold\_i}$).

**7.** Procédé selon la revendication précédente, **caractérisé en ce qu'**il comprend une étape de pause (E2) entre l'étape de charge (E1) et l'étape d'équilibrage (E3), durant laquelle la charge est interrompue.

**8.** Procédé selon l'une des revendications précédentes, **caractérisé en ce que** les éléments électrochimiques sont équilibrés jusqu'à que ce que l'écart de tension ($\Delta U_{elt}$) entre la tension la plus élevée et la tension la plus faible des éléments soit inférieur ou égal à une valeur cible d'écart de tension ($\Delta U_{elt_{target}}$), et, lors de l'étape de paramétrage, on modifie ladite valeur cible d'écart de tension.

**9.** Procédé selon l'une des revendications précédentes, **caractérisé en ce que** l'étape d'équilibrage (E3) est mise en oeuvre jusqu'à ce que l'écart entre la tension la plus forte et la tension la plus faible de l'ensemble des éléments électrochimiques soit inférieur ou égal à une valeur cible d'écart de tension.

**10.** Procédé selon l'une des revendications précédentes, **caractérisé en ce que** l'étape de paramétrage est déclenchée lorsque l'un au moins des critères suivants est détecté :

• la durée de charge et d'équilibrage est supérieure ou égale à une durée seuil prédéfinie ;
• un paramètre d'état de santé de la batterie atteint une valeur critique prédéfinie.
• un paramètre de résistance interne atteint une valeur critique prédéfinie.

**11.** Système de gestion d'un module et/ou pack batterie comportant une pluralité d'éléments électrochimiques, comprenant un module de commande (10) agencé pour commander l'exécution d'une charge suivie d'un équilibrage des éléments électrochimiques, jusqu'à ce qu'au moins une condition de charge et/ou d'équilibrage soit satisfaite, et un module de paramétrage (16) destiné à modifier ladite condition de charge et/ou d'équilibrage en cours de vie du module et/ou du pack batterie, et comprenant une mémoire (164) de stockage de données caractéristiques d'un élément du module et/ou du pack batterie relatives à une tension en circuit ouvert d'un élément électrochimique, **caractérisé en ce que** le module de paramétrage (16) est agencé pour déterminer une variation de tension en circuit ouvert ($\Delta U_{i+1}$) d'un élément électrochimique à partir des données caractéristiques de l'élément électrochimique et d'une donnée d'état de santé du module et/ou du pack batterie et, ladite condition de charge et/ou d'équilibrage étant que la tension la plus faible de l'ensemble des éléments électrochimiques soit supérieure ou égale à une tension seuil ($U_{threshold\_i}$), pour calculer une valeur modifiée de ladite tension seuil en soustrayant ladite variation de tension en circuit ouvert déterminée ($\Delta U_{i+1}$) à une valeur initiale ($U_{threshold\_0}$) de tension seuil relative à la batterie.

12. Système de gestion selon la revendication précédente, **caractérisé en ce que** la mémoire (164) stocke des données caractéristiques d'un élément du module et/ou du pack batterie relatives à une tension en circuit ouvert d'un élément électrochimique en fonction d'une charge électrique, et **en ce que** le module de paramétrage (16) est agencé pour déterminer une perte de capacité de charge d'un élément électrochimique puis une variation de tension en circuit ouvert de l'élément électrochimique correspondant à la perte de capacité de charge déterminée, à l'aide des dites données caractéristiques.

13. Système de gestion selon la revendication 11, **caractérisé en ce que** la mémoire stocke des données caractéristiques d'un élément électrochimique relatives à une variation de tension en circuit ouvert de l'élément du module et/ou du pack batterie en fonction d'un paramètre d'état de santé de l'élément, pour un état de charge électrique donné, et **en ce que** le module de paramétrage est agencé pour déterminer une donnée d'état de santé de la batterie puis une variation de tension en circuit ouvert correspondant à la donnée d'état de santé déterminée.

14. Système de gestion selon l'une des revendications 11 à 13, **caractérisé en ce qu'**une condition de charge et/ou d'équilibrage étant que l'écart de tension ($\Delta U\_elt$) entre la tension la plus élevée et la tension la plus faible des éléments électrochimiques soit inférieur ou égal à une valeur cible d'écart de tension ($\Delta U\_(elt\_target)$), le module de paramétrage est agencé pour modifier ladite valeur cible d'écart de tension.

15. Système de gestion selon l'une des revendications 11 à 14, **caractérisé en ce que** le module de paramétrage (16) comprend un bloc de déclenchement (160) agencé pour déclencher un paramétrage, sur détection de l'un des critères suivants:

   • la durée de charge et d'équilibrage est supérieure ou égale à une durée seuil prédéfinie ;
   • un paramètre d'état de santé de la batterie atteint une valeur critique prédéfinie ;
   • un paramètre de résistance interne atteint une valeur critique prédéfinie.


**Patentansprüche**

1. Verfahren zum Laden und Ausgleichen eines Batteriemoduls und/oder -packs mit elektrochemischen Elementen, umfassend mindestens einen Ladeschritt (E1) zum Laden der elektrochemischen Elemente gefolgt von einem Ausgleichsschritt (E3) zum Ausgleichen der elektrochemischen Elemente, die durchgeführt werden, bis mindestens eine Lade- und/oder Ausgleichsbedingung erfüllt ist, und einen Parametrierungsschritt (E6), der darin besteht, die Lade- und/oder Ausgleichsbedingung während der Lebensdauer des Batteriemoduls und/oder -packs zu ändern, wobei die elektrochemischen Elemente geladen werden, bis die geringste Spannung der Gesamtheit der elektrochemischen Elemente größer als oder gleich einer Schwellenspannung ($U_{threshold\_i}$) ist, **dadurch gekennzeichnet, dass** während des Parametrierungsschritts:

   • eine Leerlaufspannungsvariation ($\Delta U_{i+1}$) eines elektrochemischen Elements ausgehend von kennzeichnenden Daten des elektrochemischen Elements und eines Gesundheitszustandsdatenwerts des Batteriemoduls und/oder -packs bestimmt wird;
   • ein geänderter Wert der Schwellenspannung berechnet wird (E63), indem die bestimmte Leerlaufspannungsvariation ($\Delta U_{i+1}$) von einem Schwellenspannungsausgangswert ($U_{threshold\_0}$) der Batterie subtrahiert wird, um den Wert der Schwellenspannung zu ändern.

2. Verfahren nach Anspruch 1, **dadurch gekennzeichnet, dass** der Wert der Schwellenspannung ($U_{threshold\_i}$) ausgehend von kennzeichnenden Daten eines elektrochemischen Elements bezüglich einer Leerlaufspannung des elektrochemischen Elements in Abhängigkeit von einer elektrischen Ladung in dem Element geändert wird.

3. Verfahren nach dem vorhergehenden Anspruch, **dadurch gekennzeichnet, dass** zum Ändern des Schwellenspannungswerts:

   • ein Ladekapazitätsverlust ($\Delta Ct_{elt}$) des Elements ausgehend von einem Gesundheitszustandsdatenwert des Batteriemoduls und/oder -packs bestimmt wird (E61);
   • eine Leerlaufspannungsvariation ($\Delta U_{i+1}$) eines elektrochemischen Elements, die dem bestimmten Ladekapazitätsverlust entspricht, bestimmt wird (E62) und

• der geänderte Wert der Schwellenspannung berechnet wird (E63), indem die bestimmte Leerlaufspannungsvariation ($\Delta U_{i+1}$) von einem Schwellenspannungsausgangswert ($U_{threshold\_0}$) der Batterie subtrahiert wird.

4. Verfahren nach Anspruch 1, **dadurch gekennzeichnet, dass** der Wert der Schwellenspannung ausgehend von kennzeichnenden Daten eines elektrochemischen Elements bezüglich einer Leerlaufspannungsvariation des elektrochemischen Elements in Abhängigkeit vom Gesundheitszustand (SOH) des Elements für einen gegebenen elektrischen Ladezustand (SOC) des Elements geändert wird.

5. Verfahren nach dem vorhergehenden Anspruch, **dadurch gekennzeichnet, dass** zum Ändern des Schwellenspannungswerts:

• ein Gesundheitszustandsdatenwert (SOH) des Batteriemoduls und/oder -packs bestimmt wird;
• eine Leerlaufspannungsvariation ($\Delta U_{i+1}$), die dem bestimmten Gesundheitszustandsdatenwert entspricht, bestimmt wird; und
• ein geänderter Schwellenspannungswert berechnet wird, indem die bestimmte Leerlaufspannungsvariation von einem Schwellenspannungsausgangswert ($U_{threshold\_0}$) der Batterie subtrahiert wird.

6. Verfahren nach einem der vorhergehenden Ansprüche, **dadurch gekennzeichnet, dass** während des Ladeschritts (E1) die Gesamtheit der elektrochemischen Elemente geladen wird, bis das am stärksten geladene Element der Batterie ($U_{elt}MAX$) eine vorgegebene maximale Spannung ($U_{MAX}$) erreicht, wobei die Lade- und Ausgleichsschritte (E1, E3) wiederholt werden, bis die geringste Spannung ($U_{elt}MIN$) der Elemente der Batterie größer als oder gleich der Schwellenspannung ($U_{threshold\_i}$) ist.

7. Verfahren nach dem vorhergehenden Anspruch, **dadurch gekennzeichnet, dass** es einen Pausenschritt (E2) zwischen dem Ladeschritt (E1) und dem Ausgleichsschritt (E3) umfasst, während dessen das Laden unterbrochen ist.

8. Verfahren nach einem der vorhergehenden Ansprüche, **dadurch gekennzeichnet, dass** die elektrochemischen Elemente ausgeglichen werden, bis die Spannungsdifferenz ($\Delta U_{elt}$) zwischen der höchsten Spannung und der geringsten Spannung der Elemente kleiner als oder gleich einem Spannungsdifferenzzielwert ($\Delta U_{elt target}$) ist, und während des Parametrierungsschritts der Spannungsdifferenzzielwert geändert wird.

9. Verfahren nach einem der vorhergehenden Ansprüche, **dadurch gekennzeichnet, dass** der Ausgleichsschritt (E3) durchgeführt wird, bis die Differenz zwischen der stärksten Spannung und der geringsten Spannung der Gesamtheit der elektrochemischen Elemente kleiner als oder gleich einem Spannungsdifferenzzielwert ist.

10. Verfahren nach einem der vorhergehenden Ansprüche, **dadurch gekennzeichnet, dass** der Parametrierungsschritt ausgelöst wird, wenn mindestens eines der folgenden Kriterien festgestellt wird:

• die Lade- und Ausgleichsdauer ist größer als oder gleich einer vorgegebenen Schwellendauer;
• ein Gesundheitszustandsparameter der Batterie erreicht einen vorgegebenen kritischen Wert;
• ein Parameter für den internen Widerstand erreicht einen vorgegebenen kritischen Wert.

11. Managementsystem eines Batteriemoduls und/oder -packs mit einer Vielzahl von elektrochemischen Elementen, umfassend ein Steuermodul (10), das dazu eingerichtet ist, die Ausführung eines Ladens mit anschließendem Ausgleichen der elektrochemischen Elemente zu steuern, bis mindestens eine Lade- und/oder Ausgleichsbedingung erfüllt ist, und ein Parametrierungsmodul (16), das dazu bestimmt ist, die Lade- und/oder Ausgleichsbedingung während der Lebensdauer des Batteriemoduls und/oder -packs zu ändern, und umfassend einen Speicher (164) zum Speichern von kennzeichnenden Daten eines Elements des Batteriemoduls und/oder -packs bezüglich einer Leerlaufspannung eines elektrochemischen Elements, **dadurch gekennzeichnet, dass** das Parametrierungsmodul (16) dazu eingerichtet ist, eine Leerlaufspannungsvariation ($\Delta U_{i+1}$) eines elektrochemischen Elements ausgehend von kennzeichnenden Daten des elektrochemischen Elements und von einem Gesundheitszustandsdatenwert des Batteriemoduls und/oder -packs zu bestimmen, wobei die Lade- und/oder Ausgleichsbedingung darin besteht, dass die geringste Spannung der Gesamtheit der elektrochemischen Elemente größer als oder gleich einer Schwellenspannung ($U_{threshold\_i}$) ist, um einen geänderten Wert der Schwellenspannung zu berechnen, indem die bestimmte Leerlaufspannungsvariation ($\Delta U_{i+1}$) von einem Schwellenspannungsausgangswert ($U_{threshold\_0}$) bezüglich der Batterie subtrahiert wird.

**12.** Managementsystem nach dem vorhergehenden Anspruch, **dadurch gekennzeichnet, dass** der Speicher (164) kennzeichnende Daten eines Elements des Batteriemoduls und/oder -packs bezüglich einer Leerlaufspannung eines elektrochemischen Elements in Abhängigkeit von einer elektrischen Ladung speichert und dass das Parametrierungsmodul (16) dazu eingerichtet ist, einen Ladekapazitätsverlust eines elektrochemischen Elements und dann eine Leerlaufspannungsvariation des elektrochemischen Elements, die dem bestimmten Ladekapazitätsverlust entspricht, mithilfe der kennzeichnenden Daten zu bestimmen.

**13.** Managementsystem nach Anspruch 11, **dadurch gekennzeichnet, dass** der Speicher kennzeichnende Daten eines elektrochemischen Elements bezüglich einer Leerlaufspannungsvariation des Elements des Batteriemoduls und/oder -packs in Abhängigkeit von einem Gesundheitszustandsparameter des Elements für einen gegebenen elektrischen Ladezustand speichert und dass das Parametrierungsmodul dazu eingerichtet ist, einen Gesundheitszustandsdatenwert der Batterie und dann eine Leerlaufspannungsvariation, die dem bestimmten Gesundheitszustandsdatenwert entspricht, zu bestimmen.

**14.** Managementsystem nach einem der Ansprüche 11 bis 13, **dadurch gekennzeichnet, dass**, da eine Lade- und/oder Ausgleichsbedingung darin besteht, dass die Spannungsdifferenz ($\Delta$Uelt) zwischen der höchsten Spannung und der geringsten Spannung der elektrochemischen Elemente kleiner als oder gleich einem Spannungsdifferenzzielwert ($\Delta$U_(elt_target)) ist, das Parametrierungsmodul dazu eingerichtet ist, den Spannungsdifferenzzielwert zu ändern.

**15.** Managementsystem nach einem der Ansprüche 11 bis 14, **dadurch gekennzeichnet, dass** das Parametrierungssystem (16) einen Auslöseblock (160) umfasst, der dazu eingerichtet ist, beim Feststellen eines der folgenden Kriterien eine Parametrierung auszulösen:

• die Lade- und Ausgleichsdauer ist größer als oder gleich einer vorgegebenen Schwellendauer;
• ein Gesundheitszustandsparameter der Batterie erreicht einen vorgegebenen kritischen Wert;
• ein Parameter für den internen Widerstand erreicht einen vorgegebenen kritischen Wert.

**Claims**

**1.** Method for charging and for balancing a battery pack and/or module including electrochemical elements, comprising at least one step (E1) of charging the electrochemical elements followed by a step (E3) of balancing the electrochemical elements, which are implemented until at least one charging and/or balancing condition is met, and a parametrizing step (E6) consisting in modifying said charging and/or balancing condition during the service life of the battery pack and/or module, the electrochemical elements being charged until the lowest voltage of all of the electrochemical elements is higher than or equal to a threshold voltage ($U_{threshold\_i}$) and **characterized in that**, in the parametrizing step:

• a variation in the open-circuit voltage ($\Delta U_{i+1}$) of an electrochemical element is determined on the basis of data that are characteristic of the electrochemical element and of a datum on the state of health of the battery pack and/or module;
• a modified value of the threshold voltage is calculated (E63) by subtracting said determined variation in the open-circuit voltage ($\Delta U_{i+1}$) from an initial threshold voltage value ($U_{threshold\_0}$) of the battery in order to modify the value of the threshold voltage.

**2.** Method according to Claim 1, **characterized in that** the value of the threshold voltage ($U_{threshold\_i}$) is modified on the basis of data that are characteristic of an electrochemical element that relate to an open-circuit voltage of the electrochemical element as a function of an electric charge in the element.

**3.** Method according to the preceding claim, **characterized in that**, in order to modify the threshold voltage value:

• a loss of charge capacity ($\Delta Ct_{elt}$) of the element is determined (E61) on the basis of a datum on the state of health of the battery pack and/or module;
• a variation in the open-circuit voltage ($\Delta U_{i+1}$) of an electrochemical element corresponding to the determined loss of charge capacity is determined (E62); and
• the modified value of the threshold voltage is calculated (E63) by subtracting said determined variation in the open-circuit voltage ($\Delta U_{i+1}$) from an initial threshold voltage value ($U_{threshold\_0}$) of the battery.

4. Method according to Claim 1, **characterized in that** the value of the threshold voltage is modified on the basis of data that are characteristic of an electrochemical element that relate to a variation in the open-circuit voltage of the electrochemical element as a function of the state of health (SOH) of the element, for a given state of electric charge (SOC) of the element.

5. Method according to the preceding claim, **characterized in that**, in order to modify the threshold voltage value:

   • a datum on the state of health (SOH) of the battery pack and/or module is determined;
   • a variation in the open-circuit voltage ($\Delta U_{i+1}$) corresponding to the determined state-of-health datum is determined; and
   • a modified threshold voltage value is calculated by subtracting the determined variation in the open-circuit voltage from an initial threshold voltage value of the battery ($U_{threshold\_0}$).

6. Method according to one of the preceding claims, **characterized in that**, in the charging step (E1), all of the electrochemical elements are charged until the most charged element of the battery ($U_{elt}MAX$) reaches a predefined maximum voltage ($U_{MAX}$), said charging and balancing steps (E1, E3) being reiterated until the lowest voltage ($U_{elt}MIN$) of the elements of the battery is higher than or equal to the threshold voltage ($U_{threshold\_i}$).

7. Method according to the preceding claim, **characterized in that** it comprises a pause step (E2) between the charging step (E1) and the balancing step (E3), during which charging is interrupted.

8. Method according to one of the preceding claims, **characterized in that** the electrochemical elements are balanced until the voltage difference *($\Delta U_{elt}$)* between the highest voltage and the lowest voltage of the elements is lower than or equal to a voltage difference target value ($\Delta U_{elttarget}$), and, in the parametrizing step, said voltage difference target value is modified.

9. Method according to one of the preceding claims, **characterized in that** the balancing step (E3) is implemented until the difference between the highest voltage and the lowest voltage of all of the electrochemical elements is lower than or equal to a voltage difference target value.

10. Method according to one of the preceding claims, **characterized in that** the parametrizing step is triggered when at least one of the following criteria is detected:

    • the charging and balancing duration is longer than or equal to a predefined threshold duration;
    • a state-of-health parameter of the battery reaches a predefined critical value;
    • an internal resistance parameter reaches a predefined critical value.

11. System for managing a battery pack and/or module including a plurality of electrochemical elements, comprising a control module (10) that is arranged to control the execution of an operation of charging followed by an operation of balancing the electrochemical elements, until at least one charging and/or balancing condition is met, and a parametrizing module (16) that is intended to modify said charging and/or balancing condition during the service life of the battery pack and/or module, and comprising a memory (164) for storing data that are characteristic of an element of the battery pack and/or module that relate to an open-circuit voltage of an electrochemical element, **characterized in that** the parametrizing module (16) is arranged to determine a variation in the open-circuit voltage ($\Delta U_{i+1}$) of an electrochemical element on the basis of the data that are characteristic of the electrochemical element and of a datum on the state of health of the battery pack and/or module and, said charging and/or balancing condition being that the lowest voltage of all of the electrochemical elements is higher than or equal to a threshold voltage ($U_{threshold\_i}$), to calculate a modified value of said threshold voltage by subtracting said determined variation in the open-circuit voltage ($\Delta U_{i+1}$) from an initial threshold voltage value ($U_{threshold\_0}$) relating to the battery.

12. Management system according to the preceding claim, **characterized in that** the memory (164) stores data that are characteristic of an element of the battery pack and/or module that relate to an open-circuit voltage of an electrochemical element as a function of an electric charge, and **in that** the parametrizing module (16) is arranged to determine a loss of charge capacity of an electrochemical element followed by a variation in the open-circuit voltage of the electrochemical element corresponding to the determined loss of charge capacity, using said characteristic data.

13. Management system according to Claim 11, **characterized in that** the memory stores data that are characteristic of an electrochemical element that relate to a variation in the open-circuit voltage of the element of the battery pack and/or module as a function of a state-of-health parameter of the element, for a given state of electric charge, and **in that** the parametrizing module is arranged to determine a datum on the state of health of the battery followed by a variation in the open-circuit voltage corresponding to the determined state-of-health datum.

14. Management system according to one of Claims 11 to 13, **characterized in that**, a charging and/or balancing condition being that the voltage difference ($\Delta U\_elt$) between the highest voltage and the lowest voltage of the electrochemical elements is lower than or equal to a voltage difference target value ($\Delta U\_(elt\_target)$), the parametrizing module is arranged to modify said voltage difference target value.

15. Management system according to one of Claims 11 to 14, **characterized in that** the parametrizing module (16) comprises a triggering block (160) that is arranged to trigger a parametrizing operation upon detection of one of the following criteria:

  • the charging and balancing duration is longer than or equal to a predefined threshold duration;
  • a state-of-health parameter of the battery reaches a predefined critical value;
  • an internal resistance parameter reaches a predefined critical value.

Figure 1

Figure 2

CHG

$U_{elt}MAX \rightarrow U_{MAX}$

E1

STOP $\cong$ 1 min

E2

EQL $\rightarrow$

$\Delta U_{elt} \leq \Delta U_{elt\_target}$

E3

N

$U_{elt}MIN \geq U_{threshold}$?

E4

Y

INFO CHG **OK**

E5

**Figure 3A**

```
                              ┌────────┐
                              │  i=0   │        E6
                              └────┬───┘
                                   │
                                   ▼
```

$$SOH(t) = SOH_{crit_{i+1}}?$$ — E60

**N**  **Y**

$$\Delta Ct_{elt} = C\_elt_{t0} * \left(1 - \frac{SOH}{100}\right)$$ — E61

$$\Delta C\_elt_t \rightarrow \Delta U_{i+1}$$ — E62

$$U_{threshold\_i+1} = U_{threshold\_0} - \Delta U_{i+1}$$ — E63

$$i + 1 = N?$$ — E64

**N**  **Y**

**i=i+1**

**END**

**Figure 3B**

**Figure 4**

**Figure 5**

**Figure 6A**

**Figure 6B**

**Figure 6C**

**Figure 7**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013257382 A
- US 2013176001 A
- US 2013038296 A